# EUROPEAN PATENT SPECIFICATION

(11) **EP 4 306 977 B1**
(45) Date of publication and mention of the grant of the patent: **29.10.2025**
(21) Application number: 22904416.9
(22) Date of filing: 30.09.2022
(51) Int. Cl.: G01R 31/392, G01R 31/367, G01R 31/3835

(54) **BATTERY LIFE PREDICTION APPARATUS AND OPERATING METHOD THEREOF**
VORRICHTUNG ZUR VORHERSAGE DER BATTERIELEBENSDAUER UND DEREN BETRIEBSVERFAHREN
APPAREIL DE PRÉDICTION DE LA DURÉE DE VIE D'UNE BATTERIE ET SON PROCÉDÉ DE FONCTIONNEMENT

(30) Priority: 10.12.2021 KR 20210176327
(43) Date of publication of application: 17.01.2024
(73) Proprietor: LG Energy Solution, Ltd., Seoul 07335 (KR)
(72) Inventor: YOON, Yeo Kyung, Daejeon 34122 (KR); LEE, Jeong Min, Daejeon 34122 (KR)
(74) Representative: Plasseraud IP
(86) International application number: PCT/KR2022/014848
(87) International publication number: WO 2023/106582

(56) References cited:
- WO-A1-2021/089786
- JP-A- 2012 247 428
- KR-A- 20090 122 470
- KR-A- 20140 106 142
- KR-A- 20140 106 142
- KR-A- 20210 134 138
- KR-B1- 101 982 120
- US-A1- 2016 214 500

## Description

### [TECHNICAL FIELD]

Embodiments disclosed herein relate to a battery life prediction apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Recent batteries have a fast charging function. A fast charge time is proportional to the cycle life of the battery, such that the cycle life of the battery may be shortened as the fast charge time is reduced. Thus, it may be important to predict the cycle life of the battery with respect to a charge protocol. Due to the nature of the cycle life of the battery, a long-term test needs to be conducted, and thus there is a need for a method for predicting the cycle life of the battery based on an initial cycle.

Further background art is described in US 2016/214500 A1, KR 2014 0106142 A, and WO 2021/089786 A1.

### [DISCLOSURE]

### [TECHNICAL PROBLEM]

Embodiments disclosed herein aim to provide a battery life prediction apparatus and an operating method thereof in which a cycle life of a battery is predicted when the battery is charged according to a charge protocol.

Embodiments disclosed herein aim to provide a battery life prediction apparatus and an operating method thereof in which a cycle life of a battery may be predicted based on an initial cycle of the battery corresponding to a charge protocol.

Embodiments disclosed herein aim to provide a battery life prediction apparatus and an operating method thereof in which a life of the battery may be predicted when a fast charging protocol is used where prediction of the cycle life of the battery is impossible based on an existing capacity retention state.

Technical problems of the embodiments disclosed herein are not limited to the above-described technical problems, and other unmentioned technical problems would be clearly understood by one of ordinary skill in the art from the following description.

### [TECHNICAL SOLUTION]

The invention provides a battery life prediction apparatus according to independent claim 1. Advantageous embodiments of the present invention are defined in the dependent claims.

In an embodiment, the drive end voltage may be about 4.2 V.

In an embodiment, the specific section may be a section corresponding to 100 cycles to 200 cycles.

In an embodiment, the battery life prediction apparatus may further include a life comparing unit configured to compare lives of the battery when the battery is charged based on a plurality of charge protocols.

In an embodiment, the life comparing unit may compare the plurality of charge protocols based on a predicted cycle life of the battery corresponding to each of the plurality of charge protocols.

In an embodiment, the charge protocol may be configured with information about stepwise charging currents for the battery according to a time required for charging the battery.

The invention further provides an operating method of a battery life prediction apparatus according to independent claim 9.

### [ADVANTAGEOUS EFFECTS]

A battery life prediction apparatus and an operating method thereof according to an embodiment disclosed herein may predict a cycle life of a battery according to each charge protocol.

A battery life prediction apparatus and an operating method thereof according to an embodiment disclosed herein may predict a cycle life of a battery based on an initial cycle when the battery is charged according to a charge protocol.

A battery life prediction apparatus and an operating method thereof according to an embodiment disclosed herein may predict a life of a battery by linearly fitting a charge end voltage according to a charge cycle of the battery.

Moreover, various effects recognized directly or indirectly from the disclosure may be provided.

### [DESCRIPTION OF DRAWINGS]

FIG. 1 is a block diagram of a battery life prediction apparatus according to an embodiment disclosed herein.
FIG. 2 shows a charge end voltage of a battery according to an embodiment disclosed herein.
FIG. 3 is a flowchart of an operating method of a battery life prediction apparatus according to an embodiment disclosed herein.
FIGS. 4 and 5 are flowcharts of an operating method of a battery life prediction apparatus according to an embodiment disclosed herein.
FIG. 6 is a block diagram showing a hardware configuration of a computing system for performing an operating method of a battery life prediction apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

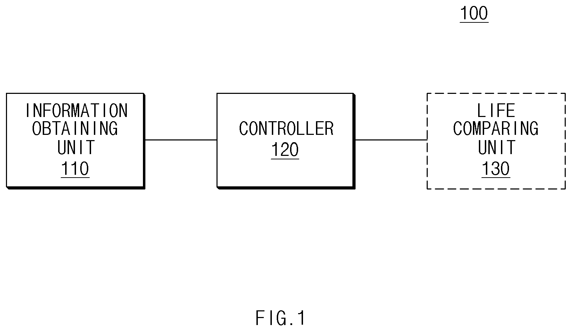

FIG. 1 is a block diagram of a battery life prediction apparatus according to an embodiment disclosed herein.

Referring to FIG. 1, a battery life prediction apparatus 100 according to an embodiment disclosed herein may include an information obtaining unit 110 and a controller 120. According to an embodiment, the battery life prediction apparatus 100 may further include a life comparing unit 130.

The information obtaining unit 110 may obtain information about a charge end voltage of the battery corresponding to a charge protocol. For example, the information obtaining unit 110 may obtain the information about the charge end voltage of the battery in every charge cycle when the battery is charged based on the charge protocol.

In an embodiment, the charge protocol may be configured with information about stepwise charging currents for the battery according to a time required for charging the battery. For example, the charge protocol may be configured with a C-rate per depth of charge of the battery. In this case, C-rate may mean the degree of a current to which a battery cell is charged for each step.

The controller 120 may predict the life of the battery corresponding to the charge protocol based on the information about the charge end voltage of the battery corresponding to the charge protocol. For example, the controller 120 may predict the cycle life of the battery corresponding to the charge protocol. In an embodiment, the controller 120 may predict the number of cycles in which the battery may be charged according to the charge protocol.

The controller 120 may linearly fit the charge end voltage of the battery corresponding to the charge protocol in every charge cycle of the battery. For example, the controller 120 may obtain the charge end voltage of the battery from the information obtaining unit 110 in every charge cycle, and fit each charge end voltage to a graph. In another example, the controller 120 may fit the charge end voltage per charge cycle of the battery to a graph of y = ax + b. In an embodiment, y may correspond to the charge end voltage of the battery, x may correspond to the charge cycle of the battery, a may correspond to a change rate of the charge end voltage of the battery per charge cycle, and b may correspond to the charge end voltage of the battery in a first charge cycle.

The controller 120 may predict a cycle in which the drive end voltage is reached as the life of the battery based on the linearly fitted graph. For example, the drive end voltage may be a voltage in which it is not possible to fast charge the battery any longer. In another example, the drive end voltage may be set to about 4.2 V. In another example, the controller 120 may calculate a cycle in which y reaches the drive end voltage in the graph y = ax +b that linearly fits the charge end voltage, and may predict the cycle as the life of the battery.

According to an embodiment, the controller 120 may select a specific section in the charge cycle of the battery. When the specific section is selected, the controller 120 may linearly fit the charge end voltage of the battery in the specific section. In this case, the controller 120 may linearly fit the charge end voltage per charge cycle of the battery to the graph y = ax + b. In an embodiment, the specific section may be a section corresponding to 100 cycles to 200 cycles. However, the disclosure is not limited thereto, and the particular section may be a cycle corresponding to n to m cycles, in which both n and m may be natural numbers and m is greater than n. In an embodiment, the controller 120 may calculate a cycle in which the drive end voltage is reached based on the graph that linearly fits the charge end voltage of the battery in the specific section, and the cycle may be predicted as the cycle life of the battery.

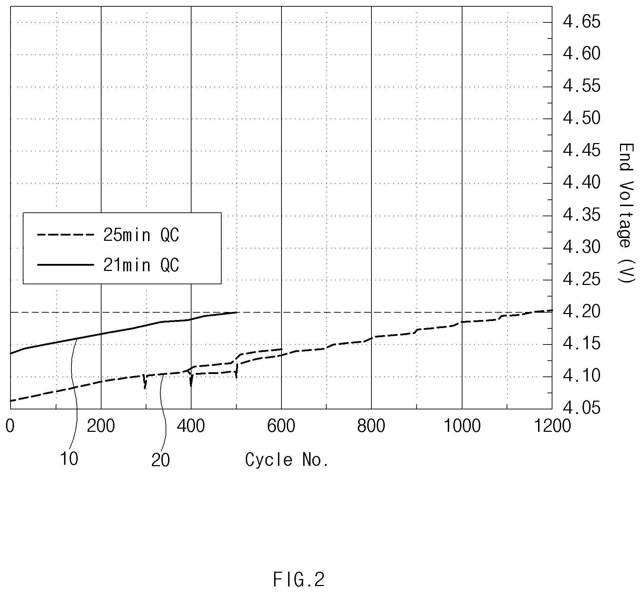

FIG. 2 shows a charge end voltage of a battery according to an embodiment disclosed herein.

Referring to FIG. 2, it may be seen that a charge end voltage 10 of a 21-minute-charge protocol is formed in a higher section than a charge end voltage 20 of a 25-minute charge protocol. As a result of linearly fitting the charge end voltage 10 of the 21-minute charge protocol, a change rate is similar to that of the charge end voltage 20 of the 25-minute charge protocol, but the charge end voltage is formed higher in a first cycle. The charging time is absolutely shortened, such that the charge end voltage of the 21-minute charge protocol is higher than the charge end voltage of the 25-minute charge protocol in the first cycle. Moreover, the change rate of the charge end voltage 10 of the 21-minute charge protocol and the change rate of the charge end voltage 20 of the 25-minute charge protocol are similar to each other because the charge protocols are merely changed for the same battery and thus a charge transfer resistance and a diffusion resistance are similar.

Moreover, the battery life prediction apparatus 100 may determine a cycle where the charge end voltage 10 of the 21-minute charge protocol reaches the drive end voltage of 4.2 V as 500 charge cycles. That is, when the battery is charged based on the 21-minute charge protocol, the charge cycle life of the battery may be determined as 500 times.

Moreover, the battery life prediction apparatus 100 may determine a cycle where the charge end voltage 20 of the 25-minute charge protocol reaches the drive end voltage of 4.2 V as 1200 charge cycles. That is, when the battery is charged based on the 25-minute charge protocol, the charge cycle life of the battery may be determined as 1200 times.

The battery life prediction apparatus 100 may determine the cycle life of the battery based on the initial charge cycle of the battery, such that the time for determining the cycle life of the battery may be saved and the cycle life of the battery may be more accurately determined.

Referring to FIG. 1, the battery life prediction apparatus 100 according to an embodiment disclosed herein may further include the life comparing unit 130.

The life comparing unit 130 may compare the lives of the battery when the battery is charged based on a plurality of charge protocols. For example, the cycle life of the battery corresponding to a case where the battery is charged using the 21-minute charge protocol may be compared with the cycle life of the battery corresponding to a case where the battery is charged using the 25-minute charge protocol.

In an embodiment, the life comparing unit 130 may compare the plurality of charge protocols based on a predicted life of the battery corresponding to each of the plurality of charge protocols.

In an embodiment, the life comparing unit 130 may determine a charge protocol having a corresponding charge cycle life according to the number of charge cycles set by a user. In this case, the life comparing unit 130 may guide the corresponding charge protocol to the user.

The battery life prediction apparatus according to an embodiment disclosed herein may predict a cycle life of a battery according to each charge protocol.

The battery life prediction apparatus according to an embodiment disclosed herein may predict a cycle life of a battery based on an initial cycle when the battery is charged according to a charge protocol.

The battery life prediction apparatus according to an embodiment disclosed herein may predict a life of a battery by linearly fitting a charge end voltage according to a charge cycle of the battery.

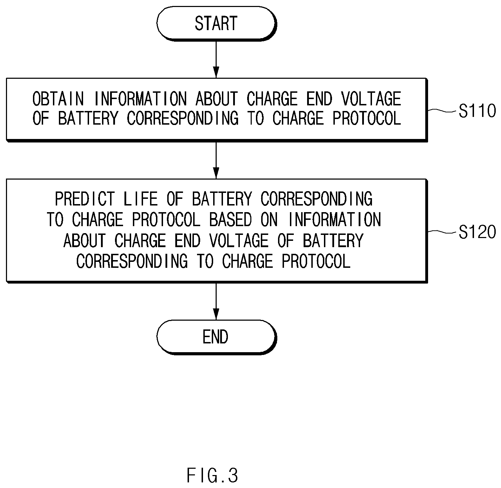

FIG. 3 is a flowchart of an operating method of a battery life prediction apparatus according to an embodiment disclosed herein.

Referring to FIG. 3, the operating method of the battery life prediction apparatus 100 according to an embodiment disclosed herein includes operation S110 of obtaining information about a charge end voltage of a battery corresponding to a charge protocol and operation S120 of predicting a life of the battery corresponding to the charge protocol based on information about the charge end voltage of the battery corresponding to the charge protocol.

In operation S110 of obtaining the information about the charge end voltage of the battery corresponding to the charge protocol, the information obtaining unit 110 may obtain the information about the charge end voltage of the battery corresponding to the charge protocol. For example, the information obtaining unit 110 may obtain the information about the charge end voltage of the battery corresponding to the charge protocol for each charge cycle of the battery. The information obtaining unit 110 may transmit the obtained information about the charge end voltage to the controller 120.

In operation S120 of predicting the life of the battery corresponding to the charge protocol based on the information about the charge end voltage of the battery corresponding to the charge protocol, the controller 120 may predict the life of the battery corresponding to the charge protocol based on the information about the charge end voltage of the battery corresponding to the charge protocol. For example, the controller 120 may predict the charge cycle life of the battery based on the information about the charge end voltage of the battery.

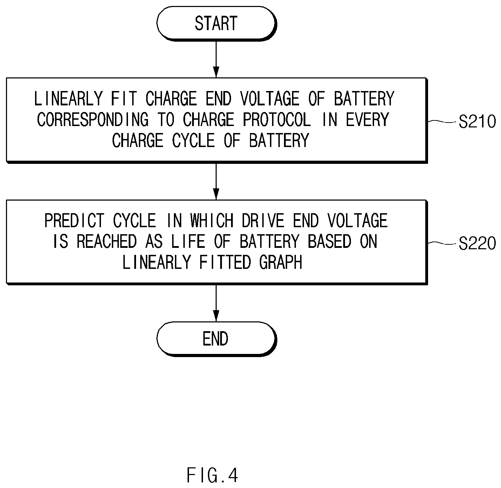

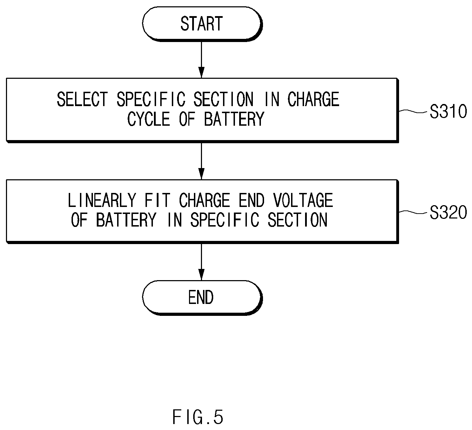

FIGS. 4 and 5 are flowcharts of an operating method of a battery life prediction apparatus according to an embodiment disclosed herein.

Referring to FIG. 4, the operating method includes operation S210 of linearly fitting the charge end voltage of the battery corresponding to the charge protocol for each charge cycle of the battery and operation S220 of predicting a cycle in which a drive end voltage is reached as the life of the battery based on the linearly fitted graph. According to an embodiment, operations S210 and S220 may be included in operation S120 of FIG. 3.

In operation S210 of linearly fitting the charge end voltage of the battery corresponding to the charge protocol for each charge cycle of the battery, the controller 120 may linearly fit the charge end voltage of the battery corresponding to the charge protocol for each charge cycle of the battery. For example, the controller 120 may linearly fit the charge end voltage of the battery to the graph y = ax + b. In an embodiment, y may correspond to the charge end voltage of the battery, x may correspond to the charge cycle of the battery, a may correspond to a change rate of the charge end voltage of the battery per charge cycle, and b may correspond to the charge end voltage of the battery in a first charge cycle.

In operation S220 of predicting the cycle in which the drive end voltage is reached as the life of the battery based on the linearly fitted graph, the controller 120 may predict the cycle in which the charge end voltage reaches the drive end voltage as the life of the battery based on the linearly fitted graph. For example, the controller 120 may predict the cycle in which the charge end voltage reaches the drive end voltage as the charge cycle life of the battery. In an embodiment, the drive end voltage may be about 4.2 V.

Referring to FIG. 5, the operating method includes operation S310 of selecting a particular section of the charge cycle of the battery and operation S320 of linearly fitting the charge end voltage of the battery in the particular section. According to an embodiment, operations S310 and S320 may be included in operation S120 of FIG. 3.

In operation S310 of selecting the particular section in the charge cycle of the battery, the controller 120 may select a specific section in the charge cycle of the battery. For example, the specific section may be a section corresponding to 100 cycles to 200 cycles. However, the disclosure is not limited thereto, and the particular section may be a cycle corresponding to n to m cycles, in which both n and m may be natural numbers and m is greater than n.

When the specific section is selected, in operation S320 of linearly fitting the charge end voltage of the battery in the specific section, the controller 120 may linearly fit the charge end voltage of the battery in the specific section. For example, the controller 120 may linearly fit the charge end voltage per charge cycle of the battery to the graph y = ax + b. In an embodiment, the controller 120 may calculate a cycle in which the drive end voltage is reached based on the graph that linearly fits the charge end voltage of the battery in the specific section, and the cycle may be predicted as the cycle life of the battery.

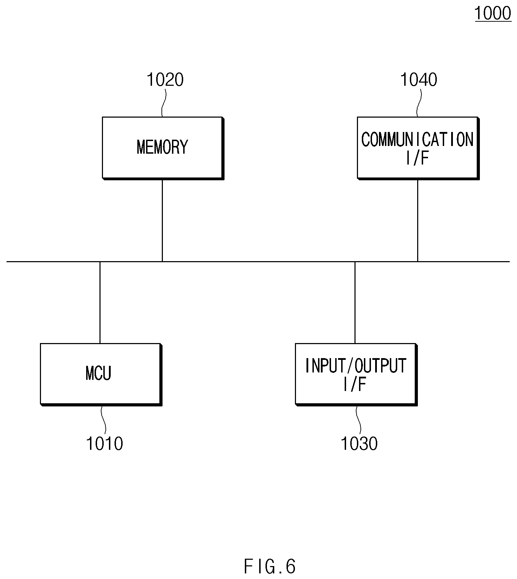

FIG. 6 is a block diagram showing a hardware configuration of a computing system for performing an operating method of a battery life prediction apparatus, according to an embodiment disclosed herein.

Referring to FIG. 6, a computing system 1000 according to an embodiment disclosed herein may include an MCU 1010, a memory 1020, an input/output I/F 1030, and a communication I/F 1040.

The MCU 1010 may be a processor that executes various programs (e.g., a battery pack voltage or current collection program, a relay control program included in a battery pack, an internal resistance calculation program, etc.) stored in the memory 1020, processes various information including a charge end voltage and a drive end voltage of a battery through these programs, and executes the above-described functions of the battery life prediction apparatus shown in FIG. 1.

The memory 1020 may store various programs regarding log information collection and diagnosis of the battery, etc. The memory 1020 may also store various information such as a current, a voltage, a charge end voltage, a drive end voltage, charge protocol information, etc., of the battery.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery life prediction apparatus may transmit and receive a relay control program included in a battery pack or information such as a current or a charge end voltage of various battery packs from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

The protection scope of the technical teaching disclosed herein is defined by the following claims.

## Claims

1. A battery life prediction apparatus (100) comprising:
an information obtaining unit (110) configured to obtain information about a charge end voltage of a battery for each charge cycle of a plurality of charge cycles of a charge protocol while the plurality of charge cycles of the charge protocol are applied to the battery; and **characterised by**
a controller (120) configured to:
generate a graph of the charge protocol for a plurality of charge end voltages of the plurality of charge cycles by linearly fitting the plurality of charge end voltages;
determine a cycle number where the graph of the charge protocol reaches a drive end voltage; and
predict a cycle life of the battery corresponding to the charge protocol as the cycle number.

2. The battery life prediction apparatus of claim 1, wherein the drive end voltage is 4.2 V.

3. The battery life prediction apparatus of claim 1, wherein the controller is further configured to select a specific section in the plurality of charge cycles of the battery and linearly fit charge end voltages in the specific section to generate the graph of the charge protocol.

4. The battery life prediction apparatus of claim 3, wherein the specific section is a section corresponding to 100 to 200 cycles.

5. The battery life prediction apparatus of claim 1, wherein the controller is further configured to predict the number of the plurality of charge cycles in which the battery is chargeable based on the cycle life of the battery.

6. The battery life prediction apparatus of claim 1, further comprising a life comparing unit (130) configured to compare lives of the battery when the battery is charged based on a plurality of charge protocols.

7. The battery life prediction apparatus of claim 6, wherein the life comparing unit is further configured to compare the plurality of charge protocols based on a predicted cycle life of the battery corresponding to each of the plurality of charge protocols.

8. The battery life prediction apparatus of claim 1, wherein the charge protocol is configured with information about stepwise charging currents for the battery according to a time required for charging the battery.

9. An operating method of a battery life prediction apparatus, the operating method comprising:
obtaining (S110) information about a charge end voltage of a battery for each charge cycle of a plurality of charge cycles of a charge protocol while the plurality of charge cycles of the charge protocol are applied to the battery;
**characterised by**
generating a graph of the charge protocol for a plurality of charge end voltages of the plurality of charge cycles by linearly fitting the plurality of charge end voltages;
determining a cycle number where the graph of the charge protocol reaches a drive end voltage; and
predicting (S120) a cycle life of the battery corresponding to the charge protocol as the cycle number.

10. The operating method of claim 9, wherein generating the graph of the charge protocol comprises:
selecting (S310) a specific section in the plurality of charge cycles of the battery; and
linearly fitting (S320) charge end voltages in the specific section to generate the graph of the charge protocol.

## Patentansprüche

1. Batterielaufzeit-Vorhersagevorrichtung (100), umfassend:
eine Informationenerlangungseinheit (110), welche dazu eingerichtet ist, Informationen über eine Ladeendspannung einer Batterie für jeden Ladezyklus einer Mehrzahl von Ladezyklen eines Ladeprotokolls zu erhalten, während die Mehrzahl von Ladezyklen des Ladeprotokolls an der Batterie angewendet werden; und
**dadurch gekennzeichnet, dass** eine Steuerungseinheit (120) dazu eingerichtet ist:
einen Graphen des Ladeprotokolls für eine Mehrzahl von Ladeendspannungen der Mehrzahl von Ladezyklen durch lineares Anpassen der Mehrzahl von Ladeendspannungen zu generieren;
eine Zykluszahl zu bestimmen, an welcher der Graph des Ladeprotokolls eine Antriebsendspannung erreicht, und
eine Zykluslaufzeit der Batterie vorherzusagen, welche dem Ladeprotokoll als die Zykluszahl entspricht.

2. Batterielaufzeit-Vorhersagevorrichtung nach Anspruch 1, wobei die Antriebsendspannung 4,2 V ist.

3. Batterielaufzeit-Vorhersagevorrichtung nach Anspruch 1, wobei die Steuerungseinheit ferner dazu eingerichtet ist, einen spezifischen Abschnitt in der Mehrzahl von Ladezyklen der Batterie auszuwählen und Ladeendspannungen in dem spezifischen Abschnitt linear anzupassen, um den Graphen des Ladeprotokolls zu generieren.

4. Batterielaufzeit-Vorhersagevorrichtung nach Anspruch 3, wobei der spezifische Abschnitt ein Abschnitt ist, welcher 100 bis 200 Zyklen entspricht.

5. Batterielaufzeit-Vorhersagevorrichtung nach Anspruch 1, wobei die Steuerungseinheit ferner dazu eingerichtet ist, die Zahl der Mehrzahl von Ladezyklen vorherzusagen, in welcher die Batterie aufladbar ist, auf Grundlage der Zykluslaufzeit der Batterie.

6. Batterielaufzeit-Vorhersagevorrichtung nach Anspruch 1, ferner umfassend eine Laufzeit-Vergleichseinheit (130), welche dazu eingerichtet ist, Laufzeiten der Batterie auf Grundlage einer Mehrzahl von Ladeprotokollen zu vergleichen, wenn die Batterie geladen wird.

7. Batterielaufzeit-Vorhersagevorrichtung nach Anspruch 6, wobei die Laufzeit-Vergleichseinheit ferner dazu eingerichtet ist, die Mehrzahl von Ladeprotokollen auf Grundlage einer vorhergesagten Zykluslaufzeit der Batterie zu vergleichen, welche jeder der Mehrzahl von Ladeprotokollen entspricht.

8. Batterielaufzeit-Vorhersagevorrichtung nach Anspruch 1, wobei das Ladeprotokoll mit Informationen über abgestufte Ladeströme für die Batterie gemäß einer Zeit eingerichtet ist, welche für ein Laden der Batterie erforderlich ist.

9. Betriebsverfahren einer Batterielaufzeit-Vorhersagevorrichtung, wobei das Betriebsverfahren umfasst:
Erhalten (S110) von Informationen über eine Ladeendspannung einer Batterie für jeden Ladezyklus einer Mehrzahl von Ladezyklen eines Ladeprotokolls, während die Mehrzahl von Ladezyklen des Ladeprotokolls an der Batterie angewendet werden;
**gekennzeichnet durch**
ein Generieren eines Graphens des Ladeprotokolls für eine Mehrzahl von Ladeendspannungen der Mehrzahl von Ladezyklen durch lineares Anpassen der Mehrzahl von Ladeendspannungen;
Bestimmen einer Zykluszahl, an welcher der Graph des Ladeprotokolls eine Antriebsendspannung erreicht; und
Vorhersagen (S120) einer Zykluslaufzeit der Batterie, welche dem Ladeprotokoll als die Zykluszahl entspricht.

10. Betriebsverfahren nach Anspruch 9, wobei das Generieren des Graphens des Ladeprotokolls umfasst:
Auswählen (S310) eines spezifischen Abschnitts in der Mehrzahl von Ladezyklen der Batterie; und
lineares Anpassen (S320) von Ladeendspannungen in dem spezifischen Abschnitt, um den Graphen des Ladeprotokolls zu generieren.

## Revendications

1. Appareil de prédiction de durée de vie de batterie (100) comprenant :
une unité d'obtention d'informations (110) configurée pour obtenir des informations sur une tension de fin de charge d'une batterie pour chaque cycle de charge d'une pluralité de cycles de charge d'un protocole de charge tandis que la pluralité de cycles de charge du protocole de charge sont appliqués à la batterie ; et **caractérisé par**
un dispositif de commande (120) configuré pour :
générer un graphique du protocole de charge pour une pluralité de tensions de fin de charge de la pluralité de cycles de charge en ajustant linéairement la pluralité de tensions de fin de charge ;
déterminer un nombre de cycles où le graphique du protocole de charge atteint une tension de fin d'excitation ; et
prédire une durée de vie en cyclage de la batterie correspondant au protocole de charge en tant que nombre de cycles.

2. Appareil de prédiction de durée de vie de batterie selon la revendication 1, dans lequel la tension de fin d'excitation est de 4,2 V.

3. Appareil de prédiction de durée de vie de batterie selon la revendication 1, dans lequel le dispositif de commande est en outre configuré pour sélectionner une section spécifique dans la pluralité de cycles de charge de la batterie et ajuster linéairement les tensions de fin de charge dans la section spécifique pour générer le graphique du protocole de charge.

4. Appareil de prédiction de durée de vie de batterie selon la revendication 3, dans lequel la section spécifique est une section correspondant à 100 à 200 cycles.

5. Appareil de prédiction de durée de vie de batterie selon la revendication 1, dans lequel le dispositif de commande est en outre configuré pour prédire le nombre de la pluralité de cycles de charge dans lesquels la batterie est rechargeable sur la base de la durée de vie en cyclage de la batterie.

6. Appareil de prédiction de durée de vie de batterie selon la revendication 1, comprenant en outre une unité de comparaison de durées de vie (130) configurée pour comparer des durées de vie de la batterie lorsque la batterie est chargée sur la base d'une pluralité de protocoles de charge.

7. Appareil de prédiction de durée de vie de batterie selon la revendication 6, dans lequel l'unité de comparaison de durées de vie est en outre configurée pour comparer la pluralité de protocoles de charge sur la base d'une durée de vie en cyclage prédite de la batterie correspondant à chacun de la pluralité de protocoles de charge.

8. Appareil de prédiction de durée de vie de batterie selon la revendication 1, dans lequel le protocole de charge est configuré avec des informations sur des courants de charge par paliers pour la batterie selon un temps requis pour charger la batterie.

9. Procédé de fonctionnement d'un appareil de prédiction de durée de vie de batterie, le procédé de fonctionnement comprenant :
l'obtention (S110) d'informations sur une tension de fin de charge d'une batterie pour chaque cycle de charge d'une pluralité de cycles de charge d'un protocole de charge tandis que la pluralité de cycles de charge du protocole de charge sont appliqués à la batterie ;
**caractérisé par**
la génération d'un graphique du protocole de charge pour une pluralité de tensions de fin de charge de la pluralité de cycles de charge par ajustement linéaire de la pluralité de tensions de fin de charge ;
la détermination d'un nombre de cycles où le graphique du protocole de charge atteint une tension de fin d'excitation ; et
la prédiction (S120) d'une durée de vie en cyclage de la batterie correspondant au protocole de charge en tant que nombre de cycles.

10. Procédé de fonctionnement selon la revendication 9, dans lequel la génération du graphique du protocole de charge comprend :
la sélection (S310) d'une section spécifique dans la pluralité de cycles de charge de la batterie ; et
l'ajustement linéaire (S320) de tensions de fin de charge dans la section spécifique pour générer le graphique du protocole de charge.
